# EUROPEAN PATENT SPECIFICATION

(11) **EP 0 726 099 B1**
(45) Date of publication and mention of the grant of the patent: **18.10.2000**
(21) Application number: 96100661.6
(22) Date of filing: 17.01.1996
(51) Int. Cl.: B08B 5/00, H01L 21/306

(54) **Method of removing surface contamination**
Verfahren zur Entfernung von Oberflächenkontamination
Procédé pour enlever la contamination de surface

(30) Priority: 26.01.1995 US 378438
(43) Date of publication of application: 14.08.1996
(73) Proprietor: TEXAS INSTRUMENTS INCORPORATED, Dallas Texas 75265 (US)
(72) Inventor: Douglas, Monte Allan, Coppel, TX 75019 (US)
(74) Representative: Schwepfinger, Karl-Heinz, Dipl.-Ing.

(56) References cited:
- WO-A-90/06189
- US-A- 5 267 455

## Description

### BACKGROUND OF THE INVENTION

The present invention relates generally to the use of dense phase gases for cleaning substrates. More particularly, the present invention relates to a process utilizing density shifting of dense phase gases or gas mixtures in order to enhance the cleaning of a wide variety of substrates, including complex materials and hardware.

### DESCRIPTION OF RELATED ART

Conventional solvent-aided cleaning processes are currently being re-evaluated due to problems with air pollution and ozone depletion. In addition, recent environmental legislation mandates that many of the organic solvents used in these processes be banned or their use severely limited. Today the environmental risks and costs associated with conventional solvent aided separation processes require industry to develop safer and more cost-effective alternatives.

The use of dense phase gases or gas mixtures for cleaning a wide variety of materials has been under investigation as an alternative to the above-mentioned solvent based cleaning processes. A dense phase gas is a gas compressed to either supercritical or subcritical conditions to achieve liquid-like densities. These dense phase gases or gas mixtures are also referred to as dense fluids. Unlike organic solvents, such as n-hexane or 1,1,1-trichloroethane, dense fluids exhibit unique physical and chemical properties such as low surface tension, low viscosity, and variable solute carrying capacity.

The solvent properties of compressed gases are well known. Inorganic salts can be dissolved in supercritical ethanol and ether. The solubility of organics such as naphthalene and phenols in supercritical carbon dioxide increases with pressure. Many organic compounds are completely miscible in liquified carbon dioxide.

Surface contaminants include discrete pieces of matter that range in size from submicrons to granules visible to observation with the human eye. Such contaminants may be fine dust or dirt particles or unwanted molecules comprised of elements, such as carbon or oxygen. There are three primary forces that contribute to the adhesion of a particle to a surface: (a) van der Waals and other electrostatic forces, (b) capillary condensation force of adhesion and (c) non-volatile contamination accumulation between the particle and surface, which region serves as a low energy nucleation site. Dense phase gases, in contrast to liquid solvents, are able to nullify the particle-surface adhesion forces associated with the latter two forces identified above, owing to their unique ability to penetrate extremely small physical domains, that one might expect of a fluid that exhibits the diffusivity and the viscosity of a gas, yet the density of a liquid. Surface tension forces associated with a liquid-solid interface prevent liquid penetration into small physical regions (e.g., crevices and high aspect ratio gaps, narrow regions between two contacting solids, etc.), that readily can be accessed by gas devoid of limiting, interfacial surface tension forces. Without the latter two forces of adhesion, the remaining electrostatic adhesion force may be overcome by simple turbulence or agitation. However, for smaller particles, e.g. less than 5 micron, boundary layer considerations limit exposure of the particle to physical agitation, making removal of such contaminants difficult.

In certain instances, the presence of surface contaminants render the contaminated substrate less efficient or inoperable for the substrate's designated purpose. For example, in certain precise scientific measurement devices, accuracy is lost when optical lenses or mirrors in the devices become coated with microfine surface contaminants. Similarly, in semiconductors, surface defects due to minor molecular contaminants often render semiconductor masks or chips worthless. Reducing the number of molecular surface defects in a quartz semiconductor mask by even a small amount can radically improve semiconductor chip production yields. Similarly, removing molecular surface contaminants, such as carbon or oxygen, from the surface of silicon wafers, before circuit layers are deposited on the wafer or between deposition of layers significantly improves the quality of the computer chip produced.

Electro-optical devices, lasers and spacecraft assemblies are fabricated from many different types of materials having various internal and external geometrical structures which are generally contaminated with more than one type of contamination. These highly complex and delicate assemblies can be classified together as "complex hardware." Conventional cleaning techniques for removing contamination from complex hardware require cleaning at each stage of assembly. In addition to the above-mentioned problems with conventional solvent aided cleaning techniques, there is also a problem of recontamination of the complex hardware at any stage during the assembly process. Such recontamination requires disassembly, cleaning, and reassembly.

WO 90/06189 discloses a cleaning process wherein the substrate to be cleaned is contacted with a dense phase gas at a pressure equal to or above the critical pressure of the dense phase gas. The phase of the dense phase gas is then shifted between the liquid state and the supercritical state by varying the temperature of the dense fluid in a series of steps between temperatures above and below the critical temperature of the dense fluid. After completion of each step in the temperature change, the temperature is maintained for a predetermined period of time in order to allow contact with the substrate and contaminants and removal of the contaminants. At each step in the temperature change, the dense phase gas posesses different cohesive energy density or solubility properties. Thereby, removal of a variety of contaminants from the substrate without the necessity of utilizing different solvents is provided. This document further mentions that the cleaning process is enhanced by exposing the dense phase gas to ultraviolet radiation during the cleaning process. The ultraviolet radiation excites certain dense phase gas molecules to increase their contaminant-removal capability.

From US-A-5,267,455, which discloses a liquid/supercritical carbon dioxide dry cleaning system, it is known that benzene may be employed as a component of the cleaning fluid.

### SUMMARY OF THE INVENTION

In accordance with the present invention, a cleaning process is provided which is capable of removing different types of contamination from a substrate in a single process. The process is especially well-suited for removing film-like contaminants such as oils, grease, flux residues and particulates less than ½ micron in size.

More particularly, there is provided a process for removing contaminants from a substrate, said process comprising the steps defined in claim 1.

The present invention is based in a process wherein the substrate to be cleaned is contacted with a dense phase gas at a pressure equal to or above the critical pressure of the dense phase gas. The density of the dense phase gas is then shifted between a higher and a lower density by varying the temperature of the dense fluid contact with the contaminant and/or surface of the substrate being treated.

The process removes contaminants from a substrate in a single process. The substrate to be cleaned is contacted with a dense phase gas at or above the critical pressure thereof. The density of the dense phase gas in contact with the contaminants and the substrate is then shifted or varied by selectively varying the temperature of the dense fluid in contact with the contaminants and the substrate. A density shift or change of at least 50 gm/liter is preferred, more preferably at least 100 gm/liter. The greatest difference in density for the smallest change in temperature is achieved by operating around the critical point of the respective dense fluid utilized. The contaminants and substrate are irradiated in a cycled manner with an irradiation which is not absorbed by the dense phase gas or the absorption of the contaminants and/or substrate is greater than that of the dense phase gas, preferably at least by a factor of 2. The cycled manner may be stepwise, ramped or pulsed. The radiation is used to increase the temperature of the contaminants and/or substrate to selectively effect a temperature and resultant density change in the dense phase gas in contact with the contaminants. The bulk of the dense phase gas virtually remains unaffected. The change in density causes particulate contaminants, particularly those less than ½ micron in size, to dislodge from the surface of the substrate.

In accordance with the invention a dopant is added to the dense gas phase which is attracted to and adheres to the contaminant and/or substrate. The dopant is sensitive to the irradiation and heats the contaminant and/or substrate. The dopant may also physically increase the contaminant particle's mass or size and surface separation by forming a "micelle-type" entity and overcome the attractive forces to the substrate. Localized agitation, as a result of density shifting, also contributes to the removal of contaminants. The dopant may be removed with the dense phase gas at the end of the cleaning operation or by adding additional dense phase gas while removing dense phase gas containing the dopant.

Further, generalized agitation, for example, as a result of mechanical or ultrasonic agitation, may also be used to aid in the removal of the contaminants once separated from the surface of the substrate. Accordingly, in an alternative embodiment of the present invention, ultrasonic or mechanical energy is also applied during the cleaning process. The ultrasonic or mechanical energy agitates the dense phase gas to provide enhanced contamination removal. Ultrasonic energy also may agitate the substrate surface to aid in contamination removal.

The above-discussed and many other features and attendant advantages of the present invention will become better understood by reference to the following detailed description when considered in conjunction with the accompanying drawings.

### BRIEF DESCRIPTION OF THE DRAWINGS

In the accompanying drawings:
FIG. 1 presents a phase diagram for carbon dioxide (CO₂), a preferred exemplary dense phase gas, in accordance with the present invention, and corresponding curves of density versus temperature and pressure.
FIG. 2 is a flowchart setting forth the steps in an exemplary process in accordance with the present invention.
FIG. 3 is a diagram of an exemplary system for use in accordance with the present invention.
FIG. 4a and FIG. 4b are schematic diagrams of exemplary racks used to load and hold the substrates to be cleaned in accordance with the present process.
FIG. 5a and FIG. 5b show an exemplary cleaning vessel for use in applying radiation to the contaminant and/or substrate through the dense phase gas during the cleaning process of first and second embodiments of the present invention.
FIG. 6 is an alternative exemplary cleaning vessel in accordance with a third embodiment of the present invention for use in also applying sonic energy during cleaning.

### DESCRIPTION OF THE INVENTION

The dense phase gases which may be used in accordance with the present invention include any of the known gases which may be converted to supercritical fluids or liquified at temperatures and pressures which will not degrade the physical or chemical properties of the substrate being cleaned. These gases typically include, but are not limited to: (1) hydrocarbons, such as methane, ethane, propane, butane, pentane, hexane, ethylene, and propylene; (2) halogenated hydrocarbons such as tetrafluoromethane, chlorodifluoromethane, sulfur hexafluoride, and perfluoropropane; (3) inorganics such as carbon dioxide, ammonia, helium, krypton, argon, and nitrous oxide; and (4) mixtures thereof. The term "dense phase gas" as used herein is intended to include mixtures of such dense phase gases. The dense phase gas selected to remove a particular contaminant is chosen to have a solubility chemistry which is similar to that of the targeted contaminant. For example, if hydrogen bonding makes a significant contribution to the internal cohesive energy content, or stability, of a contaminant, the chosen dense phase gas must possess at least moderate hydrogen bonding ability in order for solvation to occur. In some cases, a mixture of two or more dense phase gases may be formulated in order to have the desired solvent properties. The dense phase gas selected must not absorb the irradiation to be applied to the substrate or must absorb the irradiation at a much slower rate than the contaminants and/or substrate. The dense phase gas selected must also be compatible with the substrate being cleaned, and preferably has a low cost and high health and safety ratings.

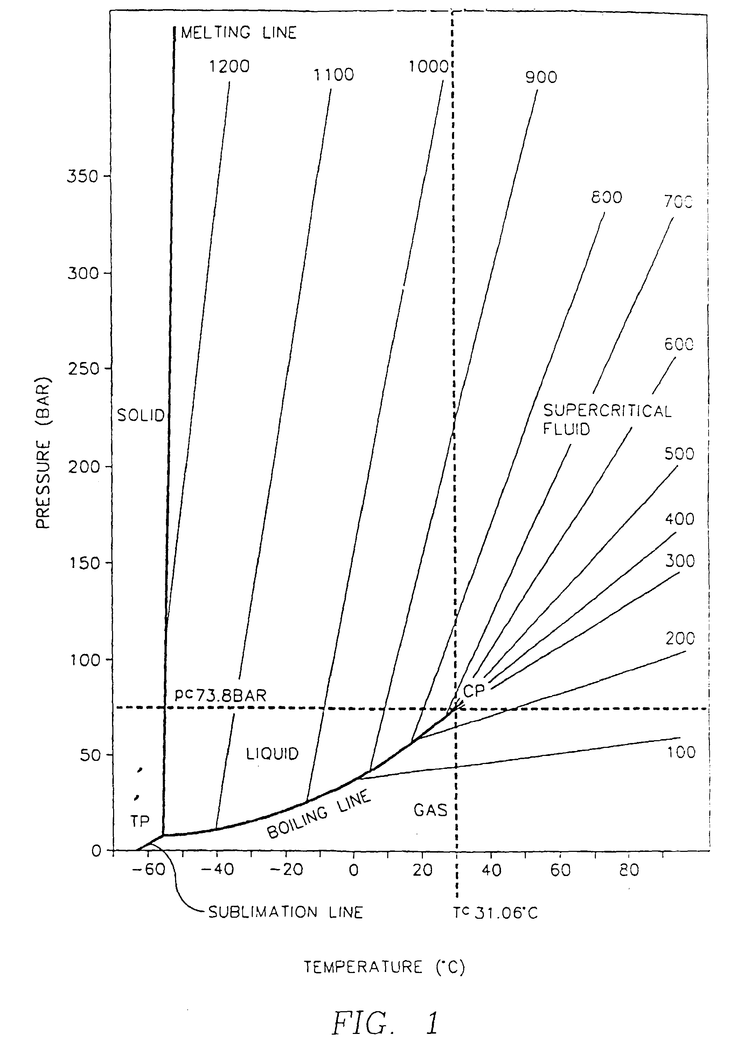

Carbon dioxide is a preferred dense phase gas for use in practicing the present invention since it is inexpensive and non-toxic. The critical temperature of carbon dioxide is about 3050 Kelvin (about 320 C.) and the critical pressure is 72.9 atmospheres. The phase diagram for carbon dioxide is set forth in FIG. 1. At pressures above the critical point, the phase of the carbon dioxide can be shifted between the liquid phase and supercritical fluid phase with the accompanying change in density by varying the temperature above or below the critical temperature of 3050 Kelvin (K). Further, near the critical point, small variations in temperature cause large variations in density.

In accordance with the present invention, a contaminated substrate is placed in contact with a single dense phase gas or gas mixture. The solubility parameter of the dense phase gas in contact with the contaminant and/or substrate is shifted in order to provide a spectrum of solvents which are capable of removing a variety of contaminants. Further, due to the volumetric change (i.e., density) of the dense phase gas in contact with particulate contaminants, the dense phase gas lifts and separates the contaminant from the surface of the substrate. This density and solubility parameter shifting is accomplished by varying the temperature of the dense phase gas in contact with the contaminant and/or substrate while maintaining the pressure at a relatively constant level which is at or above the critical pressure of the dense phase gas. The temperature of the dense phase gas in contact with the contaminant and/or substrate is varied by varying the type, duration and/or intensity of irradiation.

Increasing the temperature of dense phase carbon dioxide from 3000K to 3200K changes the gas solubility parameter from approximately 24 megapascals^{½} (MPa^{½}) to 12 MPa^{½}. (See U.S. 5,013,366) This change in solubility parameter produces a change in the solvent properties of the dense phase gas. Thus, in accordance with the present invention, the solvent properties of the dense phase gas may be controlled in order to produce a variation in solvent properties such that the dense phase gas is capable of dissolving or removing a variety of contaminants of differing chemical composition in a single treatment process. A spectrum of distinct solvents is provided from a single dense phase gas or gas mixture. The solubility parameter of the dense phase gas is matched to that of the contaminant in order to remove the contaminant. Optionally, the solubility parameter of the dense phase gas is also matched to that of the substrate in order to produce substrate swelling.

Referring to FIG. 1, increasing the temperature of dense phase carbon dioxide from about 3000K to about 3200K at about 100 bar changes the density thereof from about 725 gm/liter to about 550 gm/liter. This relatively sudden difference in density lifts and separates particulate contaminants from the surface of the substrate. This is particularly true of particulate contaminants of about ½ micron in size or smaller.

Further, since dense phase gases in the supercritical region, i.e., above the critical temperature, have densities slightly lower than a liquid and viscosities and diffusivities approaching those values typically associated with a gas, such dense phase gases are better able than classical solvents to penetrate microscopic features of the contaminants to be extracted and removed from the surface of the substrate. In regard to particulates, the dense phase gas within such microscopic features would expand and propel the particulates from the surface. In regard to films, the dense phase gas between the film and the substrate would blister and break the film apart if unable to escape quickly enough through such microscopic features. In such a state, the weakened film would be more susceptible to the solvating properties of the dense phase gas. Other organic, inorganic and elemental film contamination is removed due to the change in solvent properties of the dense phase gas and localized turbulence or agitation caused by the density shifting.

The density and solubility parameter shifting is accomplished in accordance with the present invention by a step-wise, ramped or pulsed change in the temperature of the dense phase gas in contact with the contaminant and/or substrate. This temperature change is caused by irradiating the contaminant and/or substrate with irradiation. At a constant pressure greater than the critical pressure, the temperature is preferably increased to a point above T_{c} and is then decreased to the starting temperature above T_{c}. The cycle is repeated as necessary to achieve the desired level of cleanliness. As discussed with regard to FIG. 1, as the temperature changes, the dense phase gas has different solvent properties, i.e., a different solvent exists at each temperature. Consequently, a variety of contaminants can be removed by this solvent spectrum. The change from T₁ to T₂ and back to T₁ with T₂>T₁ is referred to herein as a "temperature cycle." The starting point and/or end point for the temperature cycling of the substrate and/or contaminant may be above, below or at the critical temperature. In accordance with present process, the temperature cycle may be repeated several times, if required, in order to produce increased levels of contaminant removal. Each successive irradiation cycle and resultant temperature cycle removes more contaminants. The density shift cycle of the present invention caused by the temperature cycle also improves contaminant removal by enhancing floatation and inter-phase transfer of contaminants, thermally-aided separation of contaminants, and micro-bubble formation.

The number of times the density shift cycle is repeated, the amount of change in temperature during the cycle, and the duration of the cycle are all dependent upon the extent of contaminant removal which is required, and can readily be determined experimentally as follows. The substrate is subjected to one or more density shift cycles in accordance with the present invention, and then the substrate is examined to determine the extent of cleaning which has been accomplished. The substrate may be examined by visual or microscopic means or by testing, such as according to the American Society for Testing and Materials, Standard E595 "Total Mass Loss (TML) and Collected Volatile Condensable Material (CVCM)." Depending on the results obtained, selected process parameters may be varied and their effect on the extent of contaminant removal determined. From this data, the optimum process parameters for the particular cleaning requirements may be determined. Alternatively, the exhausted gas solvent may be analyzed to determine the amount of contaminants contained therein. Gravimetric, spectroscopic, or chromatographic analysis may be used for this purpose. The extent of contaminant removal is then correlated with the various process parameters to determine the optimum conditions to be used. Typical process parameters which have been found to be useful include, but are not limited to, the following: variation of the temperature above the critical temperature by about 5 to 100K; variation of the temperature below the critical temperature by about 5 to 25K; and variation of the temperature through the critical temperature between the extremes identified above.

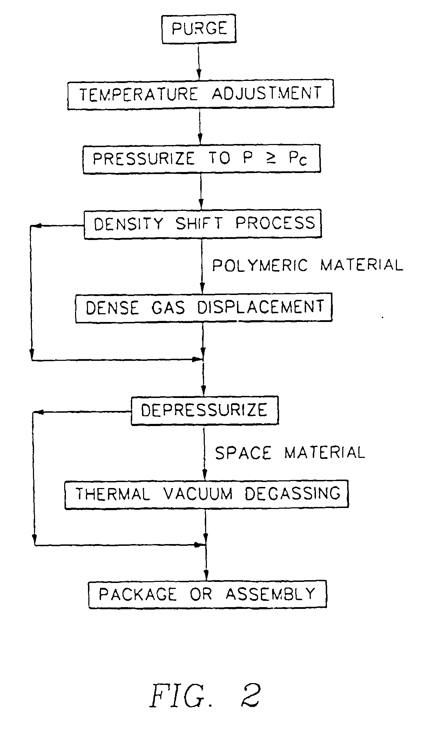

A flowchart showing the steps in the cleaning process of a first embodiment of the present invention is presented in FIG. 2. The process is carried out in a cleaning vessel which contains the substrate to be cleaned. Various exemplary cleaning vessels will be described in detail below. As shown in FIG. 2, the cleaning vessel is initially purged with an inert gas or the gas or gas mixture to be used in the cleaning process. The temperature in the pressure vessel is then adjusted to a temperature either below the critical temperature (subcritical) for the gas or gas mixture or above or equal to the critical temperature (supercritical) for the gas. The cleaning vessel is next pressurized to a pressure which is greater than or equal to the critical pressure for the gas or gas mixture. At this point, the gas is in the form of a dense fluid (i.e., dense phase gas). The density of this dense fluid is then shifted or varied between two or more values, as previously described, by varying the temperature of the dense fluid contacting the contaminant and/or substrate over a predetermined range by varying the type, duration and/or intensity of irradiation. Control of irradiation, temperature, pressure and gas flow rates is best accomplished under computer control using known methods. After shifting has been completed, the cleaning vessel is then depressurized and the treated substrate is removed and packaged or treated further.

When cleaning substrates which will be used in the space environment, the dense fluids may themselves become contaminants when subjected to the space environment. Therefore, substrates to be used in space are subjected to an additional thermal vacuum degassing step after the high pressure dense fluid cleaning process. This step is shown in FIG. 2 wherein the cleaning vessel is depressurized to a vacuum of approximately 1 Torr (millimeter of mercury) and a temperature of approximately 3950K (2500 F.) is applied for a predetermined (i.e., precalculated) period of time in order to completely degas the hardware and remove any residual gas from the hardware. The depressurization of the cleaning vessel after the cleaning process has been completed is carried out at a rate determined to be safe for the physical characteristics, such as tensile strength, of the substrate.

For certain types of substrates such as polymeric materials, internal dense fluid volumes are high upon completion of the cleaning process. Accordingly, during depressurization, the internal interstitial gas molar volume changes drastically. The gas effusion rate from the polymer is limited depending upon a number of factors, such as temperature, gas chemistry, molar volume, and polymer chemistry. In order to ease internal stresses caused by gas expansion, it is preferred that the fluid environment in the cleaning vessel be changed through dense gas displacement prior to depressurization, maintaining relatively constant molar volume. The displacement gas is chosen to have a diffusion rate which is higher than that of the dense phase gas. This step of dense gas displacement is shown in FIG. 2 as an optional step when polymeric materials are being cleaned. For example, if a non-polar dense phase cleaning fluid, such as carbon dioxide, has been used to clean a non-polar polymer, such as butyl rubber, then a polar fluid, such as nitrous oxide, should be used to displace the non polar dense fluid prior to depressurization since the polar fluid will generally diffuse more readily from the polymer pores. Alternatively, dense phase helium may be used to displace the dense phase gas cleaning fluid since helium generally diffuses rapidly from polymers upon depressurization.

The present invention may be used to clean a wide variety of substrates formed of a variety of materials. The process is especially well adapted for cleaning computer chips and parts, integrated circuit parts and complex hardware without requiring disassembly. Some exemplary cleaning applications include: removing organic and inorganic particles and/or films from computer chips; removing trace metals and metal oxides from computer chips; defluxing of soldered connectors, cables and populated circuit boards; removal of photoresists from substrates; decontamination of cleaning aids such as cotton or foam-tipped applicators, wipers, gloves, etc.; degreasing of complex hardware; and decontamination of electro optical, laser and spacecraft complex hardware including pumps, transformers, rivets, insulation, housings, linear bearings, optical bench assemblies, heat pipes, switches, gaskets, and active metal castings. Contaminant materials which may be removed from substrates in accordance with the present invention include, but are not limited to, oil, grease, lubricants, solder flux residues, photoresist, particulates and/or films comprising inorganic or organic materials, trace metals and metal oxides, adhesive residues, plasticizers, unreacted monomers, dyes, or dielectric fluids. Typical substrates from which contaminants may be removed by the present process include, but are not limited to, substrates formed of semiconductor materials, metal, rubber, plastic, cotton, cellulose, ceramics, and other organic or inorganic compounds. The substrates may have simple or complex configurations and may include interstitial spaces which are difficult to clean by other known methods. In addition, the substrate may be in the form of particulate matter or other finely divided material. The present invention has application to gross cleaning processes such as degreasing, removal of tape residues and functional fluid removal, and is also especially well adapted for precision cleaning of complex hardware to high levels of cleanliness.

In accordance with an alternative embodiment of the present invention, a mixture of dense phase gases is formulated to have specific solvent properties and irradiation absorption characteristics relative to that of the contaminants and/or substrates. The irradiation characteristics of the dense phase gas or mixtures thereof are such that in the wavelengths of interest, the gas or mixtures thereof preferably do not absorb the irradiation energy. The irradiation characteristics of gases useful as dense phase gases are well-known or within the skill of the art to determine. For example, oxygen is known to absorb such energy having wavelengths from 180 to 186 nm. See Molecular Spectra and Molecular Structure; III. Electronic Spectra and Electronic Structure of Polyatomic Molecules, D. Van Nostrand Co., Inc., Princeton, New Jersey, pp. 273, 597-598 (1967) for a partial documentation of irradiation characteristics of various gases.

In regard to solvent properties, for example, it is known that dense phase carbon dioxide does not hydrogen bond and hence is a poor solvent for hydrogen bonding compounds, such as abietic acid, which is a common constituent in solder fluxes. According to U.S. 5,013,366, the addition of 10 to 25 percent anhydrous ammonia, which is a hydrogen-bonding compound, to dry liquid carbon dioxide modifies the solvent chemistry of the latter to provide for hydrogen bonding without changing the total solubility parameter of the dense fluid system significantly. The anhydrous ammonia gas is blended with the carbon dioxide gas and compressed to liquid-state densities, namely the subcritical or supercritical state. These dense fluid blends of CO₂ and NH₃ are useful for removing polar compounds, such as plasticizers from various substrates. In addition to possessing hydrogen-bonding ability, the carbon dioxide/ammonia dense fluid blend can dissolve ionic compounds, and is useful for removing residual ionic flux residues from electronic hardware. This particular dense phase solvent blend has the added advantage that it is environmentally acceptable and can be discharged into the atmosphere. Similar blends may be made using other non-hydrogen-bonding dense fluids, such as blends of ammonia and nitrous oxide or ammonia and xenon.

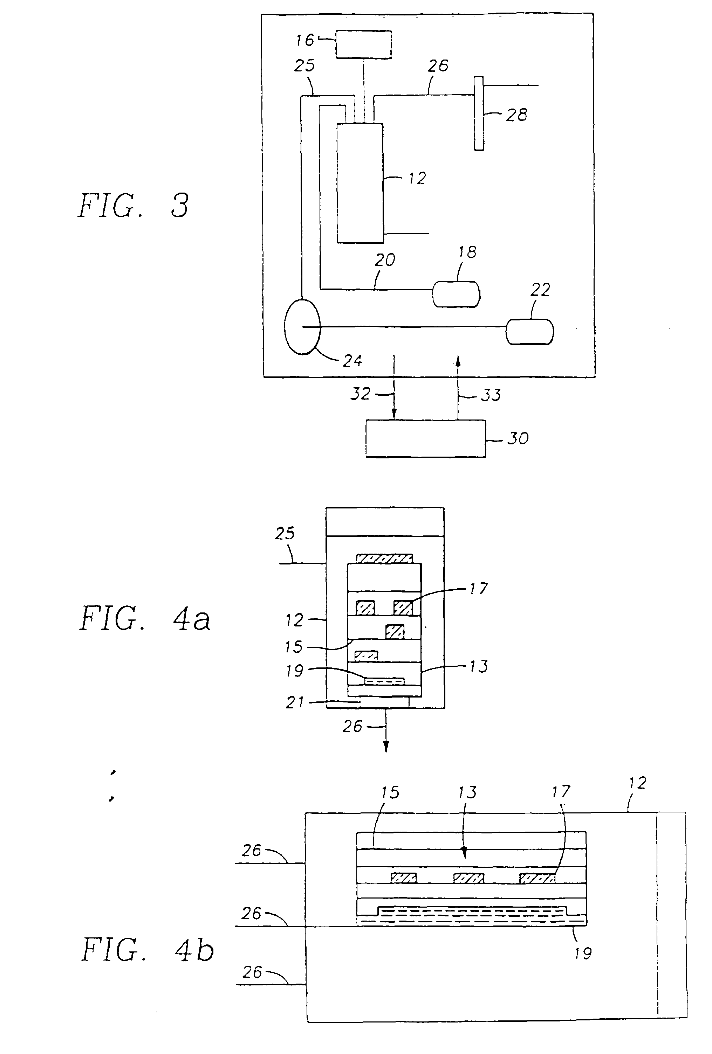

An exemplary system for carrying out the process of the present invention is shown diagrammatically in FIG. 3. The system includes a high pressure cleaning chamber or vessel 12. The substrate is placed in the chamber 12 on a loading rack as shown in FIG. 4a or FIG. 4b. The temperature within the chamber 12 is controlled by an external heater assembly (not shown) which is powered by power unit 16 which is used in combination with a cooling system (not shown) surrounding the cleaning vessel. Coolant is introduced from a coolant reservoir 18 through coolant line 20 into a coolant jacket or other suitable structure (not shown) surrounding the high pressure vessel 12. The dense fluid used in the cleaning process is fed from a gas reservoir 22 into the chamber 12 through pressure pump 24 and inlet line 25. The system may be operated for batch-type cleaning or continuous cleaning. For batch-type cleaning, the chamber 12 is pressurized to the desired level and the temperature of the dense phase gas is adjusted to above the critical temperature of the dense phase gas. After the cleaning process is completed, the resulting dense fluid containing contaminants is removed from the chamber 12 through exhaust line 26. The cleaning vessel may be repressurized with dense phase gas and depressurized as many times as required during the cleaning process. The exhaust line may be connected to a separator 28 which removes the entrained contaminants from the exhaust gas thereby allowing recycling of the dense phase gas. Density shifting by irradiation cycling is continued and the above-described depressurization and repressurizations are performed as required to achieve the desired level of cleanliness of the substrate.

For continuous cleaning processes, the dense fluid is introduced into chamber 12 by pump 24 at the same rate that contaminated gas is removed through line 26 in order to maintain the pressure in chamber 12 at or above the critical pressure. This type of process provides continual removal of contaminated gas while the density of the dense fluid within chamber 12 which is in contact with the contaminants and/or the substrate is being varied through irradiation cycling.

The operation of the exemplary system shown schematically in FIG. 3 may be controlled by a computer 30 which utilizes menu-driven advanced process development and control (APDC) software.

The analog input, such as temperature and pressure of the chamber 12, is received by the computer 30 as represented by arrow 32. The computer provides digital output, as represented by arrow 33 to control the various valves, heating and cooling systems in order to maintain the desired pressure and temperature within the chamber 12, and the irradiation system. The various programs for the computer will vary depending upon the chemical composition and geometric configuration of the particular substrate being cleaned, the contaminant(s) being removed, the particular dense fluid cleaning gas or gas mixture, and the cleaning times needed to produce the required end-product cleanliness.

Referring to FIGS. 2 and 3, an exemplary cleaning process involves initially placing the substrates into the cleaning vessel, chamber 12. The chamber 12 is closed and purged with clean, dry inert gas or the cleaning gas from reservoir 22. The temperature of the chamber 12 is then adjusted utilizing the external heating element (not shown) powered by power unit 16 and coolant from reservoir 18 to which is provided externally through a jacketing system, in order to provide a temperature either equal to or above the critical temperature for the cleaning gas or gas mixtures. The chamber 12 is then pressurized utilizing pump 24 to a pressure equal to or above the critical pressure for the particular dense phase gas cleaning fluid.

Once the pressure in chamber 12 reaches the desired point above the critical pressure, the pump 24 may be continually operated and exhaust line 26 opened to provide continuous flow of dense fluid through the chamber 12 while maintaining constant pressure. Alternatively, the exhaust line 26 may be opened after a sufficient amount of time at a constant pressure drop to remove contaminants, in order to provide for batch processing.

In accordance with the present invention, enhancement of the cleaning action of the dense fluid may be provided by exposing the substrate to irradiation. The irradiation excites the molecules of the substrate and/or contaminate to increase their temperature and thereby increase the temperature of the dense phase gas in contact with the substrate and/or containment and causes the density of the dense phase gas to change. This density shift or change causes the removal of the contaminants, for example, by dislodging particulate contaminants.

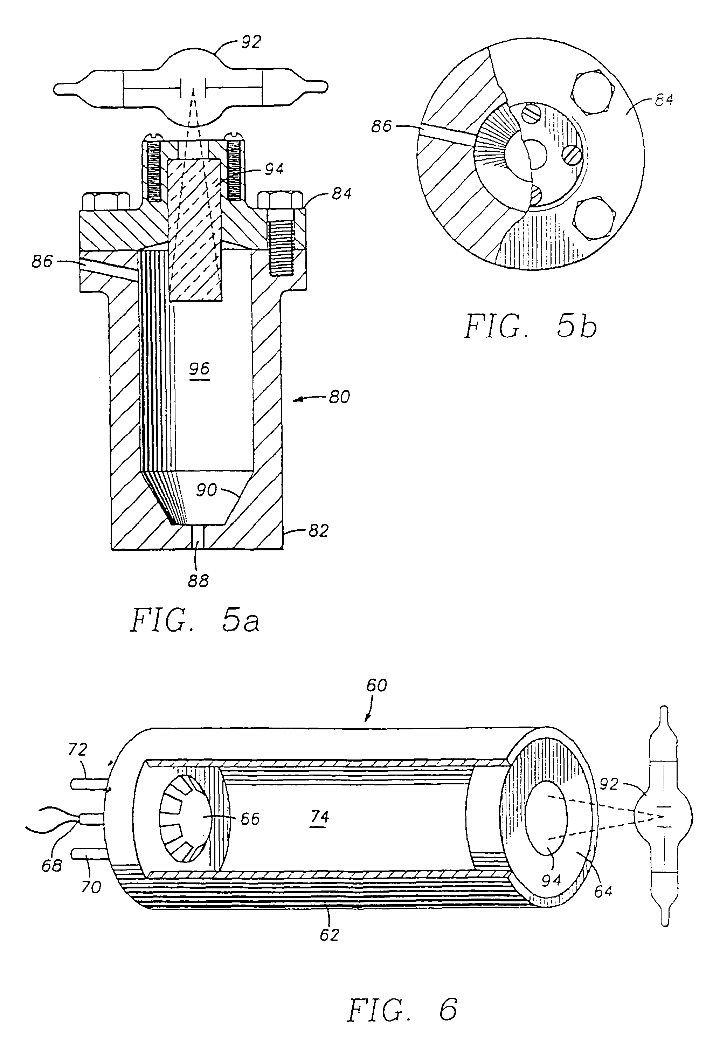

An exemplary cleaning vessel for carrying out such irradiation-enhanced cleaning is shown at 80 in FIGS. 5a and 5b. The cleaning vessel 80 includes a container 82 which has a removable container cover 84, gas solvent feed port 86 which has an angled bore to provide for enhanced mixing in the chamber, and solvent exhaust port 88. The interior surface 90 preferably includes a radiation-reflecting liner. Various types of irradiation may be used, for example, ultraviolet radiation, visible light radiation and infrared radiation having wavelengths of 180 to 350 nanometers, 351 to 900 nanometers and 900 to 41,000 nanometers, respectively. Xenon flash lamps are suitable to provide such visible light radiation. Operation of the lamp may be either pulsed or continuous. A high pressure quartz window 94, which extends deep into the chamber to achieve a light piping effect, is provided in the container cover 84 through which radiation is directed into the cleaning chamber 96. Temperature control within the cleaning chamber 96 is provided by an external heating element and cooling jacket (not shown). The container 82 and cover 84 are made from conventional materials which are chemically compatible with the dense fluids used and sufficiently strong to withstand the pressures necessary to carry out the process, such as stainless steel or aluminum.

FIGS. 4a and 4b shows two exemplary racks which may be used to load and hold the substrates to be cleaned in accordance with the present invention. FIG. 4a shows a vertical configuration, while FIG. 4b shows a horizontal configuration. In FIGS. 4a and 4b, the following elements are the same as those shown in FIG. 3: chamber or pressure vessel 12 gas inlet line 25, and gas outlet line(s) 26. A rack 13 with shelves 15 is provided to hold the substrates 17 to be treated in accordance with the present process. The rack 13 and shelves 15 are made of a material which is chemically compatible with the dense fluids used, do not absorb the irradiation, and sufficiently strong to withstand the pressures necessary to carry out the present process. Preferred materials for the rack and shelves are stainless steel or teflon. The shelves 15 are constructed with perforations or may be mesh in order to insure the unobstructed flow of the dense fluid and heat transfer from the substrates and/or contaminants. The rack 13 may have any convenient shape, such as cylindrical or rectangular, and is configured to be compatible with the particular pressure vessel used. The vertical configuration of FIG. 4a is useful with a pressure vessel of the type shown in FIGS. 5a and 5b herein, whereas the horizontal configuration of FIG. 4b is useful with a horizontal pressure vessel. As shown in FIG. 4a, legs or "standoffs" 21 are provided in order to elevate the rack above the bottom of the vessel 12. As indicated in FIG. 4b, the rack is held on stand-offs (not shown) so that it is located in the upper half of the chamber in order to prevent obstruction of fluid flow. Optionally, in both of the configurations of FIGS. 4a and 4b, an additive reservoir 19 may be used in order to provide a means of modifying the dense phase gas by addition of a selected material, such as methanol or hydrogen peroxide. The reservoir 19 comprises a shallow rectangular or cylindrical tank. The modifier is placed in the reservoir 19 when the substrate is loaded into the chamber 12. The modifier may be a free-standing liquid or it may be contained in a sponge-like absorbent material to provide more controlled release. Vapors of the modifier are released from the liquid into the remainder of the chamber 12 during operation of the system. The modifier is chosen to enhance or change certain chemical properties of the dense phase gas. For example, the addition of anhydrous ammonia to xenon provides a mixture that exhibits hydrogen bonding chemistry, which xenon alone does not. Similarly, the modifier may be used to provide oxidizing capability or reducing capability in the dense phase gas, using liquid modifiers such as ethyl alcohol, water, acid, base, or peroxide.

In a second embodiment of the present invention, the cleaning action of the dense fluid during density shifting may be enhanced by applying ultrasonic energy to the cleaning zone. A suitable high-pressure cleaning and sonifier are shown at 60 in FIG. 6. The sonifier 60 includes a cylindrical container 62 having removable enclosure 64 at one end and ultrasonic transducer 66 at the other end. The transducer 66 is connected to a suitable power source by way of power leads 68. Such transducers are commercially available, for example, from Delta Sonices of Los Angeles, California. Gas solvent feed line 70 is provided for introductions of the dense fluid solvent into the cleaning zone 74. Exhaust line 72 is provided for removal of contaminated dense fluid.

The sonifier 60 is operated to apply sonic energy to the dense fluid during density shifting in accordance with the present invention. The frequency applied may be within the range of about 20 and 80 kilohertz. The frequency may be held constant or, preferably,may be shifted back and forth over the range of 20 to 80 kilohertz. The use of ultrasonic energy (sonification) increases cleaning power by aiding in dissolving and/or suspending bulky contaminants, such as waxes, monomers and oils, in the dense fluid. Furthermore, operation of the sonic cleaner with high frequency sonic bursts agitates the dense phase gas and the substrate to promote the breaking of bonds between the contaminants and the substrate being cleaned. Though they may be used separately, use of sonification in combination with density shifting has the added advantage that the sonification tends to keep the chamber walls clean and assists in removal of extracted or dislodged contaminants.

The cleaning vessels shown in FIGS. 5 and 6 are exemplary only and other possible cleaning vessel configurations may be used in order to carry out the process of the present invention. For example, a wide variety of external and internal heating and cooling elements may be utilized in order to provide the necessary temperature control and a wide variety of irradiation sources may be used to accomplish density shifting of the dense fluid.

In accordance with the present invention, the dense fluid may comprise a mixture of a first dense phase fluid and a dopant. The dense phase fluid which serves as a carrier for the dopant. The dopant would selectively react or be attracted to the substrate surface and/or contaminant. The dopant would also contain chemical groups which are sensitive to certain types of irradiation. Accordingly, upon exposure to such irradiation, these groups would excite the molecules of the dopant and increase the temperature of the substrate and contaminants together with the dense phase gas in contact therewith. This increase in temperature would cause a shift in density to dislodge particulate contaminants and/or increase the solvating characteristics of a dense phase gas at the surface of the substrate.

As noted above, the type of irradiation used is dependent on the substrate and contamination present. With this in mind, the dense phase gas is selected which does not absorb the type of irradiation to be used or absorb it at a much lower rate than the substrate and/or contaminant. Alternatively, a dopant can be added to the dense phase gas when both the dense phase gas and the substrate and/or contaminants are non-responsive to the type of irradiation used. In either case, the objective is to selectively increase the temperature of the contaminants and/or substrate to shift the density of the dense phase gas in contact therewith. There would also be a temperature and density gradient of the dense phase gas in a direction normal to the surface of the substrate. This would encourage the transport of the contaminants from the surface once dislodged or removed into the dense phase gas by diffusion. This thermal gradient also provides "solvent zones," that is a range of distinct solvents favoring certain contaminants or contaminant groups, which enhances the contaminant removal process.

The type of irradiation which is used with the present invention is visible light radiation. If pulsed, pulsed widths on the order of milliseconds to nanoseconds with pulse rates from 5Hz to 100kHz may be used.

The irradiation type is chosen based on the desired dense phase gas chosen or vice-versa such that the irradiation chosen is not absorbed by the dense phase gas.

In regard to the dopants, the various chemical groups attached to the dopant which respond to the above-identified types of irradiation usually include aromatic or multiply bonded groups, for example, double and triple bonds. Examples of dopants that would be suitable and useful include benzene, acetylene, phthalocyanines and perfluoropolyethers. Such groups would absorb visible light radiation. Groups that absorb infrared energy also are known in the art.

Regarding the dense phase gas going through a phase change in order to remove particulate contaminants, going through a solid or liquid phase change at the surface of the substrate (1) enhances the turbulence of the dense phase gas due to density changes and (2) changes the attractive characteristics of the dense phase gas relative to the contaminant and between the contaminant and the substrate surface. Such may blind the contaminant to the substrate surface and enhance the removal of the contaminant, particularly particulate contaminants. Further, to take advantage of such a phenomenon, it is preferable to operate close to the solid/liquid phase boundary or solid/dense fluid boundary such that small temperature changes would allow this phase transition to occur together with the associated density shift.

The present invention provides an effective method for removing one or more contaminants from a given substrate in a single process. The types of contaminants removed in accordance with the present invention may have a wide variety of compositions and the substrates may vary widely in chemical composition and physical configuration.

The process of the present invention has wide application to the preparation of structures and materials for both terrestrial and space environments including gaskets, insulators, cables, metal castings, heat pipes, bearings, rivets and electrical and computer components. The particular cleaning fluid and density shifting conditions utilized will vary depending upon the particular contaminants desired to be removed. The process is also especially well-suited for removing greases and oils from both internal and external surfaces of complex hardware.

Having thus described exemplary embodiments of the present invention, it should be noted by those skilled in the art that within the disclosures they are exemplary only and that various other alternatives, adaptations, and modifications may be made within the scope of the present invention. For example, the continuous system described in U.S. 5,313,965 to Palen could be modified to incorporate an irradiation system in the processing zone (14 therein) thereof. Accordingly, the present invention is not limited to the specific embodiments as illustrated herein, but is only limited by the following claims.

## Claims

1. A method for removal of surface contaminants from a substrate surface, comprising the steps of
a) contacting a surface of a substrate with a dense phase gas;
b) shifting the phase of said dense phase gas at said surface by varying the temperature of said dense phase gas at said surface with radiation;
said method being characterised in that
- said dense phase gas contains dopants which are selected from the group consisting of benzene, acetylene, phthalocyanines and perfluoropolyesthers, and that
- said radiation is visible light which is not substantially absorbed by said dense phase gas and which is adapted to excite the dopants to enhance the removal of said contaminants.

## Patentansprüche

1. Verfahren zum Entfernen von Oberflächenverunreinigungen von einer Substratoberfläche mit den Schritten:
a) Bringen einer Oberfläche eines Substrats in Kontakt mit einem Gas in dichter Phase,
b) Verschieben der Phase des Gases dichter Phase an der Oberfläche durch Ändern der Temperatur des Gases in dichter Phase an der Oberfläche durch Strahlung,
dadurch gekennzeichnet, daß
das Gas in dichter Phase Dotierungsstoffe enthält, die aus der aus Benzol, Acetylen, Phthalocyaninen und Perfluorpolyestern bestehenden Gruppe ausgewählt werden, und daß
die Strahlung aus sichtbarem Licht besteht, das nicht in erheblichem Maße von dem Gas in dichter Phase absorbiert wird und das in der Lage ist, die Dotierungsstoffe anzuregen, um das Entfernen der Verunreinigungen zu verbessern.

## Revendications

1. Procédé pour éliminer des contaminants de surface d'une surface d'un substrat, comprenant les étapes consistant à :
a) placer un gaz à phase dense en contact avec une surface d'un substrat;
b) décaler la phase dudit gaz à phase dense sur ladite surface en modifiant la température dudit gaz à phase dense sur ladite surface à l'aide d'un rayonnement
ledit procédé étant caractérisé en ce que
- ledit gaz à phase dense contient des dopants qui sont choisis dans le groupe comprenant le benzène, l'acétylène, des phtalocyanines et des perfluoropolyesters, et que
- ledit rayonnement est une lumière visible, qui n'est pas absorbée substantiellement par ledit gaz à phase dense et qui est adaptée pour exciter les dopants de manière à améliorer l'élimination dudit contaminant.
